(19) Europäisches Patentamt
European Patent Office
Office européen des brevets

(11) EP 3 214 747 B1

(12) **EUROPÄISCHE PATENTSCHRIFT**

(45) Veröffentlichungstag und Bekanntmachung des Hinweises auf die Patenterteilung:
**27.11.2019 Patentblatt 2019/48**

(51) Int Cl.:
*H02M 1/32* (2007.01)     *H02M 3/335* (2006.01)

(21) Anmeldenummer: **17156022.0**

(22) Anmeldetag: **14.02.2017**

(54) **ELEKTRISCHE VORRICHTUNG MIT EINEM GETAKTETEN NETZTEIL UND VERFAHREN ZUM ÜBERPRÜFEN DES NETZTEILS DER ELEKTRISCHEN VORRICHTUNG**

ELECTRICAL DEVICE HAVING A SWITCHED POWER SUPPLY AND METHOD FOR CHECKING THE POWER SUPPLY OF THE ELECTRICAL DEVICE

DISPOSITIF ÉLECTRIQUE DOTÉ D'UNE PARTIE DE RÉSEAU CADENCÉE ET PROCÉDÉ DE CONTRÔLE DE LA PARTIE DE RÉSEAU DU DISPOSITIF ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.03.2016 DE 102016203355**

(43) Veröffentlichungstag der Anmeldung:
**06.09.2017 Patentblatt 2017/36**

(73) Patentinhaber: **KUKA Deutschland GmbH**
**86165 Augsburg (DE)**

(72) Erfinder: **ZEHETBAUER, Sebastian**
**81673 München (DE)**

(74) Vertreter: **Ege Lee & Partner**
**Patentanwälte PartGmbB**
**Schirmgasse 268**
**84028 Landshut (DE)**

(56) Entgegenhaltungen:
**WO-A1-00/33095     DE-A1-102012 219 318**

**Beschreibung**

Die Erfindung betrifft eine elektrische Vorrichtung, insbesondere eine elektrische Maschine mit einem getakteten Netzteil und ein Verfahren zum Testen des Netzteils der elektrischen Vorrichtung.

Die DE 10 2012 219 318 A1 offenbart eine elektrische Vorrichtung, insbesondere eine elektrische Maschine, die einen elektrischen Verbraucher, ein getaktetes Netzteil, wenigstens einen Impulsübertrager und eine Auswertevorrichtung aufweist. Das Netzteil umfasst ein Leistungsteil mit wenigstens einem Leistungshalbleiterschalter und ist eingerichtet, aus einer elektrischen Spannung aufgrund eines abwechselnden Ein- und Ausschaltens des wenigstens einen Leistungshalbleiterschalters eine getaktete elektrische Spannung für den elektrischen Verbraucher zu erzeugen. Das Leistungsteil weist wenigstens einen Strompfad auf, durch den im Betrieb des Netzteils ein elektrischer Strom fließt. Die Auswertevorrichtung ist eingerichtet, ein vom Impulsübertrager stammendes Signal auszuwerten und aufgrund des ausgewerteten Signals auf die Funktionstüchtigkeit des Leistungshalbleiterschalters zu schließen.

Aufgabe der Erfindung ist es, eine verbesserte Möglichkeit anzugeben, einen elektronischen Schalter einer elektrischen Vorrichtung im laufenden Betrieb der elektrischen Vorrichtung verbessert zu überprüfen.

Die Aufgabe der Erfindung wird gelöst durch eine elektrische Vorrichtung, aufweisend

- einen elektrischen Verbraucher,
- einen elektronischen Schalter, der ein elektronisches Schaltelement und eine das elektronische Schaltelement ansteuernde Treibervorrichtung umfasst,
- ein getaktetes Netzteil, welches ein Leistungsteil mit dem elektronischen Schaltelement aufweist und das eingerichtet ist, aus einer elektrischen Spannung aufgrund eines abwechselnden Ein- und Ausschaltens des einen elektronischen Schaltelements eine elektrische Versorgungspannung oder einen elektrischen Versorgungsstrom für den elektrischen Verbraucher zu erzeugen, wobei das Leistungsteil einen Strompfad aufweist, durch den im Betrieb des Netzteils ein dem elektronischen Schaltelement des elektronischen Schalters zugeordneter elektrischer Strom fließt,
- wenigstens einen Impulsübertrager, der eine Primärseite mit einer primärseitigen Wicklung und eine Sekundärseite mit einer sekundärseitigen Wicklung aufweist und der mit seiner Primärseite derart in das Leistungsteil geschaltet ist, dass durch die primärseitige Wicklung der dem elektronischen Schaltelement des elektronischen Schalters zugeordnete elektrischer Strom fließt, wobei der Impulsübertrager auf seiner Sekundärseite derart schwach belastet ist, dass die an der sekundärseitigen Wicklung anliegende sekundärseitige elektrische Spannung zumindest annähernd proportional zur zeitlichen Änderung des dem elektronischen Schaltelement des elektronischen Schalters zugeordneten elektrischen Stroms ist,
- einen Schwellwertentscheider, der eingerichtet ist, die sekundärseitige elektrische Spannung oder eine durch Filterung der sekundärseitigen elektrischen Spannung erzeugte gefilterte sekundärseitige elektrische Spannung mit einer Referenzspannung zu vergleichen, die insbesondere einer zeitlichen Änderung eines elektrische Stromes zugeordnet ist, die dem vollständig funktionstüchtigen elektronischen Schalter zugeordnet ist, und
- eine mit dem Schwellwertentscheider gekoppelte Auswertevorrichtung, welche eingerichtet ist, aufgrund des mit dem Schwellwertentscheider durchgeführten Vergleichs einen potenziellen Defekt des elektronischen Schalters zu erkennen.

Die Aufgabe wird auch gelöst durch ein Verfahren zum Überprüfen des Netzteils der erfindungsgemäßen elektrischen Vorrichtung, aufweisend folgende Verfahrensschritte:

- abwechselndes Öffnen und Schließen des elektronischen Schaltelements,
- Vergleichen der sekundärseitige elektrische Spannung oder der gefilterten sekundärseitigen elektrischen Spannung mit der Referenzspannung, und
- Schließen auf einen potenziellen Defekt des elektronischen Schalters aufgrund des Vergleichs.

Die erfindungsgemäße Vorrichtung ist beispielsweise eine elektrische Maschine, wie z.B. ein Roboter, und umfasst das getaktete Netzteil, welches vorgesehen ist, den elektrischen Verbraucher der erfindungsgemäßen Vorrichtung mit der elektrischen Versorgungsspannung bzw. dem elektrischen Versorgungsstrom zu versorgen. Die elektrische Versorgungsspannung ist insbesondere eine durch Taktung geregelte Spannung bzw. der elektrische Versorgungsstrom ist insbesondere ein durch Taktung geregelter elektrischer Strom.

Der elektrische Verbraucher ist insbesondere ein induktiver Verbraucher, vorzugsweise eine elektromechanische Bremse. Der induktive Verbraucher kann beispielsweise auch ein Relais oder die Primärwicklung eines Leistungsübertrages bzw. einer Leistungsinduktivität für ein beliebiges Schaltnetzteil oder ein Motor in Verbindung mit einer mehrphasigen Brückenschaltung (Frequenzumrichter) sein. Elektromechanische Bremsen werden z.B. bei Robotern verwendet, um eines der Glieder dessen Roboterarms insbesondere in einer Notsituation zu bremsen. Roboter umfassen in der Regel einen Roboterarm und eine Steuervorrichtung. Der Roboterarm weist mehrere, hintereinander angeordnete und über Gelenke verbundene Glieder und elektrische Motoren zum Bewegen der Glieder relativ zueinander auf.

Die erfindungsgemäße Vorrichtung umfasst den elektronischen Schalter, der das elektronische Schaltelement und die das elektronische Schaltelement ansteuernde Treibervorrichtung umfasst. Der elektronische Schalter ist vorzugsweise ein Halbleiterschalter. In diesem Fall ist das elektronische Schaltelement als ein Transistor ausgebildet. Der Transistor ist insbesondere ein Leistungstransistor.

Das getaktete Netzteil umfasst das Leistungsteil, welches z.B. als eine H-Brücke ausgebildet ist. Das Leistungsteil umfasst das Schaltelement des elektronischen Schalters. Das Leistungsteil ist vorgesehen, aus einer elektrischen Spannung z.B. aufgrund eines abwechselnden Ein- und Ausschaltens des elektronischen Schaltelements die Versorgungsspannung bzw. den Versorgungsstrom für den elektrischen Verbraucher zu erzeugen.

Das Leistungsteil ist beispielsweise als ein Wechselrichter ausgeführt.

Im Betrieb des Netzteils bzw. der erfindungsgemäßen elektrischen Vorrichtung wird insbesondere das elektronische Schaltelement, gesteuert durch die Treibervorrichtung, abwechselnd geschlossen und geöffnet. Dazu umfasst das Netzteil z.B. eine geeignete Ansteuerelektronik, wie dies dem Fachmann im Prinzip bekannt ist. Die Ansteuerelektronik steuert die Treibervorrichtung des elektrischen Schalters derart an, dass das elektronische Schaltelement entsprechend öffnet bzw. schließt.

Um im laufenden Betrieb der elektrischen Vorrichtung bzw. deren Netzteils die Funktionstüchtigkeit des elektronischen Schalters zu überprüfen, um insbesondere einen sich anbahnenden oder potenziellen Defekt der Treibervorrichtung des elektrischen Schalters möglichst frühzeitig zu erkennen, ist der Impulsübertrager vorgesehen.

Impulsübertrager als solche sind dem Fachmann bekannt. Diese umfassen eine Primärseite mit der primärseitigen Wicklung. Der primärseitigen Wicklung ist eine primärseitige Induktivität L1 zugeordnet und die primärseitige Wicklung umfasst n1 Windungen. Impulsübertrager weisen auch eine Sekundärseite mit einer sekundärseitigen Wicklung auf. Der sekundärseitigen Wicklung ist eine sekundärseitige Induktivität L2 zugeordnet und die sekundäseitige Wicklung umfasst n2 Windungen. Somit weisen Impulsübertrager ein Übersetzungsverhältnis Primärseite zu Sekundärseite von n1:n2 bzw. ein Übersetzungsverhältnis Sekundärseite zu Primärseite von n2:n1 auf.

Der Impulsübertrager ist primärseitig derart mit dem Leistungsteil verschaltet, dass durch die primärseitige Wicklung der dem elektronischen Schaltelement zugeordnete elektrische Strom fließt.

Beispielsweise kann der elektronische Schalter Teil des Strompfades sein, durch den im Betrieb des Netzteils der dem elektronischen Schaltelement zugeordnete elektrische Strom fließt. In diesem Fall fließt durch die primärseitige Wicklung des Impulsübertrages der elektrische Strom, der auch durch das elektronische Schaltelement fließt.

Des Weiteren ist erfindungsgemäß der Impulsübertrager auf seiner Sekundärseite derart schwach belastet, dass die sekundärseitige elektrische Spannung, die an der sekundärseitigen Wicklung des Impulstransformators anliegt, zumindest annähernd proportional zur zeitlichen Änderung des dem elektronischen Schaltelement des elektronischen Schalters zugeordnete elektrischen Stroms ist.

Impulsübertrager weisen z.B. ein Übersetzungsverhältnis n1:n2 von 1:20...1:100 auf. Allerdings wird erfindungsgemäß der Impulsübertrager nicht, wie meist üblich, als Transformator mit einem definiertem Arbeitswiderstand in der als Stromtransformator üblichen Beschaltung auf der Sekundärseite betrieben, sondern sekundärseitig mit einem derart schwach belastetem Ausgang, sodass die Primärseite (Eingangsseite) des Impulsübertragers im Unterschied zur Beschaltung als energieübertragender Transformator wie eine Induktivität wirkt (unbelasteter Transformator), auf der sich primärseitig eine der Änderung des primärseitigen elektrischen Stroms zumindest annähernd proportionale primärseitige elektrische Spannung ausbildet. Die primärseitige elektrische Spannung liegt an der primärseitigen Wicklung an. Dadurch entsteht entsprechend dem Übersetzungsverhältnis des Impulsübertragers auf der Sekundärseite bzw. Ausgangsseite des Impulstransformators die sekundärseitige elektrische Spannung, welche für Messungen zur Verfügung steht.

Dieses Grundprinzip kann aber auch in Anwendungen mit relativ hohen Leistungen eingesetzt werden (Energieversorgung, elektronische Netzfrequenzumformung, Überwachung von z.B. GTOs oder IGBTs).

Als Grundlage zur Berechnung der quantitativ auswertbaren Stromänderungsgeschwindigkeit am zu überwachenden elektronischem Schaltelement werden insbesondere die folgenden Gleichungen benutzt.

Die Ausgangsspannung des Impulsübertragers, d.h. die sekundärseitige elektrische Spannung U2 ist gegeben durch die Eingangsspannung, d.h. die primärseitige elektrische Spannung U1 des Impulsübertragers, also:

$$U2 = n2/n1*U1$$

Für die primärseitige elektrische Spannung U1 (Eingangsspannung) des sekundärseitigen unbelasteten Impulsübertrages gilt die Beziehung

$$U1 = L1*di/dt$$

wobei di/dt die zeitliche Änderung des durch die Primärseite fließenden elektrischen Stroms ist.

Die Kombination beider Ausdrücke liefert

$$U2 = n2/n1*L1*di/dt$$

Diese Gleichung gilt für den Impulsübertrager der erfindungsgemäßen Vorrichtung zumindest annähernd, sodass die sekundärseitige elektrische Spannung zumindest annähernd proportional zur zeitlichen Änderung des dem elektronischen Schaltelement des elektronischen Schalters zugeordneten elektrischen Stroms ist.

Erfindungsgemäß ist der Schwellwertentscheider vorgesehen, der für die sekundärseitige elektrische Spannung, der insbesondere im Zusammenspiel mit dem gewählten Impulsübertrager und dessen technischen Daten im Vergleich zu einer vorzugsweise frei wählbaren Referenzspannung erkennt, wenn insbesondere eine mindestens festgelegte Schaltgeschwindigkeit im Strompfad erreicht wird. An einem Ausgang des Schwellwertentscheiders steht dann ein Signal zur weiteren Auswertung zur Verfügung. Dieses Signal wird von der Auswertevorrichtung ausgewertet.

Die mindestens festgelegte Schaltgeschwindigkeit im Strompfad kann notwendig sein, um z.B. in getakteten leistungselektronischen Schaltungen einen relativ verlustleistungsarmen Betrieb der verwendeten elektronischen Leistungsschalter zu gewährleisten. Sollte aufgrund eines Defekts in der Treiberschaltung des elektronischen Leistungsschalters oder des elektronischen Leistungsschalters selbst die Schaltgeschwindigkeit zu langsam werden, so ist eine erhöhte Schaltverlustleistung zu erwarten und es könnte eine erhöhte und möglicherweise zerstörerische Temperatur auftreten.

Durch die Überwachung der Schaltgeschwindigkeit kann ein sich ankündigender Defekt erkannt und behandelt werden, bevor Folgefehler oder weitreichende Bauteil - oder Baugruppenausfälle zu Tage treten.

Beispielsweise kann ein einziger Impulsübertrager in Kombination mit zwei ausgangsseitigen Schwellwertentscheidern benutzt werden, um sowohl einen Einschaltvorgang (steigende Stromänderung di/dt > 0) als auch den Ausschaltvorgang (fallende Stromänderung di/dt < 0) des elektronischen Schalters zu überwachen. Dadurch kann gegebenenfalls eine relativ differenzierte Diagnose des überwachten elektronischen Schalters möglich sein.

Somit ergibt sich insbesondere eine Überwachung der Schaltgeschwindigkeit des elektronischen Schalters.

Der Schwellwertentscheider ist z.B. ein Operationsverstärker, ein Komparator oder ein bipolarer Transistor.

Bei Kenntnis der auszuwertenden Schaltgeschwindigkeit kann zudem mit Hilfe eines Filters, insbesondere eines Tiefpassfilters sekundärseitig für Robustheit z.B. gegen transiente, eingekoppelte Störungen gesorgt werden. Einerseits erlaubt die Auslegung des Impulsübertragers die Auswertung einer Mindest-Stromanstiegsgeschwindigkeit, andererseits dämpft das Filter besonders schnelle und kurze Ereignisse. Dadurch kann die Robustheit der Auswertevorrichtung gegenüber eingekoppelte Störimpulse verbessert werden.

Gemäß einer Variante der elektrischen Vorrichtung weist diese vorzugsweise einen dem Impulsübertrager sekundärseitig nachgeschalteten Tiefpassfilter auf, der eingerichtet ist, aus der sekundärseitigen elektrischen Spannung die gefilterte sekundärseitige elektrische Spannung zu erzeugen.

Gemäß einer Ausführungsform der elektrischen Vorrichtung kann die Auswertevorrichtung eingerichtet sein, aufgrund des mit dem Schwellwertentscheider durchgeführten Vergleichs für einen Ein- oder Ausschaltvorgang des elektronischen Schaltelemets einen potenziellen Defekt des elektronischen Schalters zu erkennen. Im Falle des potenziellen Defekts schaltet nämlich der elektronische Schalter z.B. aufgrund eines möglichen Fehlers im elektronischen Schaltelement selbst oder in seiner Treibervorrichtung langsamer als vorgesehen.

Vorzugsweise erzeugt der Schwellwertentscheider ein Ausgangssignal, welches sich ändert, sobald die sekundärseitige elektrische Spannung oder die gefilterte sekundärseitige elektrische Spannung die Referenzspannung überschreitet.

Die Auswertevorrichtung ist vorzugsweise eingerichtet, auf einen potenziellen Defekt des elektronischen Schalters zu schließen, wenn trotz eines Ein- oder Ausschaltvorgangs des elektronischen Schalters die sekundärseitige elektrische Spannung oder die gefilterte sekundärseitige elektrische Spannung die Referenzspannung stets unterschreitet.

Somit kann das erfindungsgemäße Verfahren folgenden Verfahrensschritt aufweisen: Schließen auf einen potenziellen Defekt des elektronischen Schalters, wenn trotz eines Ein- oder Ausschaltvorgangs des elektronischen Schalters die sekundärseitige elektrische Spannung oder die gefilterte sekundärseitige elektrische Spannung die Referenzspannung stets unterschreitet.

Ausführungsbeispiele der Erfindung sind exemplarisch in den beigefügten schematischen Zeichnungen dargestellt. Es zeigen:

Fig. 1    einen Roboter mit einem Roboterarm in einer perspektivischen Darstellung,

Fig. 2    einen Prinzipschaltplan,

Fig. 3    einen Schaltplan einer elektrischen Schaltung, und

Fig. 4    Simulationsergebnisse für die elektrische Schaltung der Fig. 3.

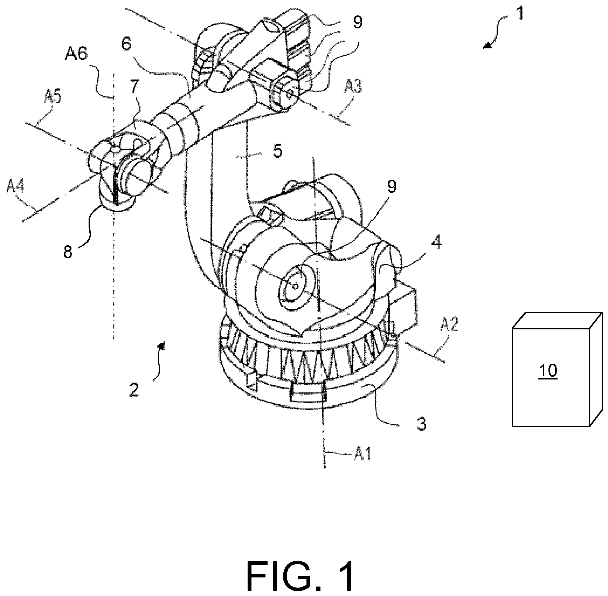

Die Fig. 1 zeigt einen Roboter 1 mit einem Roboterarm 2 in einer perspektivischen Darstellung.

Der Roboterarm 2 umfasst im Falle des vorliegenden Ausführungsbeispiels mehrere, nacheinander angeordnete und durch Gelenke verbundene Glieder. Bei den Gliedern handelt es sich insbesondere um ein ortsfestes oder bewegliches Gestell 3 und ein relativ zum Gestell 3 um eine vertikal verlaufende Achse A1 drehbar gelagertes Karussell 4. Weitere Glieder des Roboterarms 2 sind im Falle des vorliegenden Ausführungsbeispiels eine Schwinge 5, ein Ausleger 6 und eine vorzugsweise mehrachsige Roboterhand 7 mit einer z.B. als Flansch 8 ausgeführten Befestigungsvorrichtung zum Befestigen eines nicht näher dargestellten Endeffektors. Die Schwinge 5 ist am unteren Ende z.B. an einem nicht näher dargestellten Schwingenlagerkopf auf dem Karussell 4 um eine vorzugsweise horizontale Achse A2 schwenkbar gelagert. Am oberen Ende der Schwinge 5 ist wiederum um eine ebenfalls vorzugsweise horizontale Achse A3 der Ausleger 6 schwenkbar gelagert. Dieser trägt endseitig die Roboterhand 7 mit ihren vorzugsweise drei Achsen A4, A5, A6.

Um den Roboter 1 bzw. dessen Roboterarm 2 zu bewegen, umfasst dieser in allgemein bekannter Weise mit einer Steuervorrichtung 10 verbundene elektrische Antriebe. In der Figur 1 sind nur einige der elektrischen Motoren 9 dieser elektrischen Antriebe gezeigt, welche im oder am Roboterarm 2 befestigt sind. Leistungselektroniken der elektrischen Antriebe sind z.B. innerhalb eines Gehäuses eines nicht näher dargestellten Steuerschranks angeordnet, innerhalb dem z.B. auch die Steuervorrichtung 10 angeordnet ist. Die elektrischen Motoren 9 sind im Falle des vorliegenden Ausführungsbeispiels Drehstrommotoren, beispielsweise Drehstrom-Synchronmotoren. Die Leistungselektroniken können aber auch im und/oder am Roboterarm 2 angeordnet sein.

Die Leistungselektroniken umfassen im Falle des vorliegenden Ausführungsbeispiels, wie dies dem Fachmann im Prinzip bekannt ist, einen nicht näher dargestellten Gleichrichter, welcher aus der Netzspannung eine Gleichspannung erzeugt, einen dem Gleichrichter nachgeschalteten, ebenfalls nicht näher dargestellten Zwischenkreis mit einem Zwischenkreiskondensator zum Glätten der Gleichspannung und mehrere, dem Zwischenkreiskondensator nachgeschaltete Umrichter bzw. Wechselrichter.

Auf der Steuervorrichtung 10, welche z.B. als ein Computer ausgeführt ist, läuft ein Rechenprogramm, mittels dem die Steuervorrichtung 10 im Betrieb des Roboters 1 diesen beispielsweise derart ansteuert, dass der Flansch 8 oder ein sogenannter Tool Center Point eine vorbestimmte Bewegung ausführt. Gegebenenfalls regelt die Steuervorrichtung 10 die elektrischen Antriebe, wie dies im Prinzip dem Fachmann bekannt ist. Gegebenenfalls sind die elektrischen Antriebe geregelte elektrische Antriebe und die Steuervorrichtung 10 erzeugt Soll-Signale für die geregelten elektrischen Antriebe bzw. deren Wechselrichter.

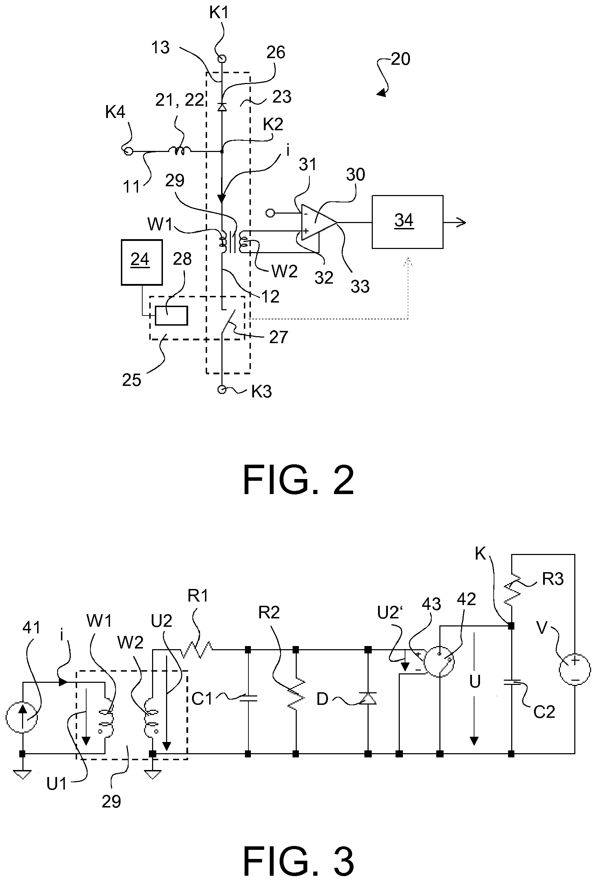

Im Falle des vorliegenden Ausführungsbeispiels umfasst der Roboter 1 elektromechanische Bremsen zum Bremsen der einzelnen Glieder. Die Bremsen sind derart ausgeführt, dass sie im gelösten Zustand mittels einer mit einem elektrischen Strom beaufschlagten Induktivität gehalten werden. Wird die Induktivität abgeschaltet, dann löst die Bremse automatisch aus und bremst das ihr zugeordnete Glied des Roboterarms 2. Dazu umfassen die Bremsen beispielsweise vorgespannte Federn. Die Fig. 2 zeigt beispielsweise die Induktivität 21 der zum Bremsen des Karussells 4 vorgesehenen Bremse.

Um im Betrieb des Roboters 1 die Bremse in ihrem gelösten Zustand zu halten bzw. von ihrem ausgelösten in ihren gelösten Zustand zu bringen, umfasst der Roboter 1 im Falle des vorliegenden Ausführungsbeispiels den Bremsen zugeordnete getaktete Netzteile.

In der Fig. 2 ist ein Schaltplan des der Bremse des Karussells 4 zugeordnetem getakteten Netzteils 20 teilweise gezeigt. Die Induktivität 21 stellt somit einen elektrischen Verbraucher, insbesondere einen induktiven Verbraucher 22 für das Netzteil 20 dar.

Das Netzteil 20 umfasst im Falle des vorliegenden Ausführungsbeispiels ein Leistungsteil 23 und eine Ansteuerelektronik 24, die eingerichtet ist, das Leitungsteil 23 anzusteuern. Die Ansteuerelektronik 24 ist z.B. Teil der Steuervorrichtung 10.

Das in der Fig. 2 teilweise gezeigte Netzteil 21 ist z.B. derart ausgeführt, dass dessen Leistungsteil 23 als eine nur teilweise dargestellte H-Brücke ausgeführt ist. H-Brücken als solche sind dem Fachmann im Prinzip bekannt.

Das Leistungsteil 23 des Netzteils 20 umfasst im Falle des vorliegenden Ausführungsbeispiels mehrere elektrische Pfade, durch die im Betrieb des Netzteils 20 elektrische Ströme fließen. Das Netzteil 20 umfasst im Falle des vorliegenden Ausführungsbeispiels wenigstens einen elektronischen Schalter 25. Der elektronische Schalter 25 ist insbesondere als ein Halbleiterschalter, vorzugsweise als ein Leistungshalbleiterschalter ausgeführt und umfasst ein elektronisches Schaltelement und eine das elektronische Schaltelement ansteuernde Treibervorrichtung 28. Das elektronische Schaltelement ist beispielsweise ein Transistor 27. Der Transistor 27 kann in FET Technologie ausgeführt sein. Er kann auch ein bipolarer Transistor sein.

Im Falle des vorliegenden Ausführungsbeispiels umfasst das Leistungsteil 23 den Transistor 27, allgemein das elektronische Schaltelement, und eine Freilaufdiode 26.

Das Leistungsteil 23 wird z.B. von einer elektrischen Versorgungsspannung versorgt, die insbesondere eine elektrische Gleichspannung ist und an einem ersten Knoten K1 anliegt. Diese wird z.B. aus der Netzspannung mittels Gleichrichtung und anschließender Glättung erzeugt.

Im Falle des vorliegenden Ausführungsbeispiels ist die Topologie des Leistungsteils 23 folgendermaßen:

Die Freilaufdiode 26 ist einerseits mit dem ersten Knoten K1 und andererseits mit einem zweiten Knoten K2 in Sperrrichtung verbunden. Der Transistor 27 ist einerseits mit dem zweiten Knoten K2 und einem dritten Knoten K3 verbunden. Der dritte Knoten K3 ist z.B. mit einem Bezugspotenzial, z.B. mit Masse verbunden.

Zwischen dem zweiten Knoten K2 und einem vierten Knoten K4 ist die Induktivität 21 der Bremse geschaltet.

Die Induktivität 21 ist Teil eines ersten Strompfads 11, der Transistor 27 ist Teil eines zweiten Strompfads 12 und die Freilaufdiode 28 ist Teil eines dritten Strompfades 13.

Im Falle des vorliegenden Ausführungsbeispiels werden im Normalbetrieb, d.h. in einem Betrieb, in dem die Bremse gelöst ist und somit ihr relevantes Glied nicht bremst, der Transistor 27 abwechselnd ein und ausgeschaltet. Insbesondere wird dieser mittels eines pulsweitenmodulierten Signals ein- und ausgeschaltet.

Im Falle des vorliegenden Ausführungsbeispiels ist es vorgesehen, die Bremsen in ihrem gelösten Zustand mittels des Netzteils 20 mit einem elektrischen Strom zu beaufschlagen. Dadurch wird der elektronische Schalter 25 bzw. dessen als Transistor ausgebildetes elektronisches Schaltelement in geeigneter Weise mittels der Ansteuerelektronik 24, welche das pulsweitenmodulierten Signal erzeugt, ein und ausgeschaltet. Die Ansteuerelektronik 24 steuert dazu die Treibervorrichtung 28 des elektronischen Schalters 25 in für den Fachmann in Prinzip bekannter Weise an.

Aufgrund der Ansteuerung des elektronischen Schalters 25 bzw. dessen Treibervorrichtung 28 wird das als Transistor 27 ausgeführte elektronische Schaltelement abwechselnd zwischen seinem leitenden bzw. niederohmigen Zustand und seinem sperrenden bzw. hochohmigen Zustand entsprechend dem pulsweitenmodulierten Signal hin- und hergeschaltet.

Wie bereits beschrieben, löst die Bremse aus, wenn durch ihre Induktivität 21 dauerhaft kein elektrischer Strom mehr fließt. Dies wird erreicht, indem der elektronische Schalter 25 bzw. dessen als Transistor 27 ausgeführtes elektronisches Schaltelement dauerhaft geöffnet bleibt bzw. dauerhaft in seinen sperrenden Zustand verharrt.

Um die Funktionstüchtigkeit des elektronischen Schalters 25 auch im laufenden Betrieb bzw. Normalbetrieb des Roboters 1 zu überprüfen, d.h. um die Funktionstüchtigkeit des elektronischen Schalters 25 auch bei gelöster Bremse zu überprüfen, umfasst der Roboter 1 im Falle des vorliegenden Ausführungsbeispiels einen Impulsübertrager 29.

Der Impulsübertrager 29 umfasst eine Primärseite mit einer primärseitigen Wicklung W2, der eine primärseitige Induktivität L1 zugeordnet ist und die n1 Windungen umfasst. Der Impulsübertrager 29 umfasst und eine Sekundärseite mit einer sekundärseitig Wicklung W2, der eine sekundärseitige Induktivität L2 zugeordnet ist und die n2 Windungen umfasst. Der Impulsübertrager 29 weist ein Übertragungsverhältnis von n1:n2 auf (Primärseite/Sekundärseite).

Der Impulübertrager 29 ist im Falle des vorliegenden Ausführungsbeispiels in Serie mit dem als Transistor 27 ausgeführten elektronischen Schaltelement geschaltet, sodass durch die primärseitige Wicklung W1 und durch das Schaltelement 27 der elektrische Strom i des zweiten Strompfades 12 fließt.

Der Impulsübertrager 29 ist sekundärseitig derart schwach belastet, dass zumindest annähernd Folgendes gilt:

$$U2 = n2:n1 * U1 = n2:n1 * L1 * di/dt$$

wobei U1 die primärseitige elektrische Spannung des Impulstransformator 29 ist, die an der primärseitigen Wicklung W1 anliegt, und U2 die sekundärseitige elektrische Spannung des Impulstransformator 29 ist, die an der sekundärseitigen Wicklung W2 anliegt.

Somit ist die sekundärseitige elektrische Spannung U2 zumindest annähernd proportional zur zeitlichen Änderung des elektrischen Stroms i, der durch das als Transistor 27 ausgebildete elektronische Schaltelement fließt.

Das Schaltnetzteil 20 umfasst im Falle des vorliegenden Ausführungsbeispiels einen Schwellwertentscheider 30, der z.B. als Operationsverstärker ausgeführt ist.

Der Schwellwertentscheider 30 umfasst z.B. einen ersten Eingang 31 und einen zweiten Eingang 32, an dem die sekundärseitige Spannung U2 anliegt. Am ersten Eingang 31 liegt eine Referenzspannung $U_{ref}$ als Referenzsignal an. Das Referenzsignal kann statisch sein oder bei Bedarf im laufenden Betrieb dynamisch angepasst werden.

Der Schwellwertentscheider 30 umfasst einen Ausgang 33, an dem ein Ausgangssignal anliegt. Diesem sind zwei logische Werte zugeordnet, d.h. das Ausgangssignal weist einen ersten Wert auf, solange die an seinem zweiten Eingang 32 anliegende sekundärseitige elektrische Spannung U2 kleiner als die Vergleichsspannung $U_{ref}$ ist. Ist die am zweiten Eingang 32 anliegende sekundärseitige elektrische Spannung U2 größer als die Referenzspannung $U_{ref}$, dann weist das Ausgangssignal einen vom ersten Wert unterschiedlichen zweiten Wert auf.

Wie bereits erläutert, gilt zumindest annähernd

$$U2 = n2:n1 * L1 * di/dt.$$

Die Referenzspannung $U_{ref}$ bzw. das Referenzsignal ist im Falle des vorliegenden Ausführungsbeispiels derart gewählt, dass das Ausganssignal seinen zweiten Wert annimmt, wenn die zeitliche Änderung des Stroms i durch den Transistor 27 einen vorbestimmten Wert überschreitet. Dieser vorbestimmte Wert ist dem voll funktionstüchtigen elektronischen Schalter 25 zugeordnet. Ändert sich der elektrische Strom i beim Schalten zu langsam, dann überschreitet die sekundärseitige elektrische Spannung U2 die Referenzspannung $U_{ref}$ nicht, woraufhin auf einen sich anbahnenden Defekt des elektronischen Schalters 25 geschlossen werden kann.

Das Ausgangssignal kann dann von einer Auswertevorrichtung 34 ausgewertet werden. Die Auswertevorrichtung 34 kann Teil der Steuervorrichtung 10 sein.

Es kann auch vorgesehen sein, dass der Impulsübertragers 29 in Serie mit der Freilaufdiode 26 geschaltet ist, sodass die zeitliche Änderung des elektrischen Stroms durch die Freilaufdiode 26 analysiert wird. Dieser elektrische Strom ist ebenfalls ein dem elektronischem Schaltelement 25 zugeordneter elektrischer Strom.

Mit Kenntnis über die Schaltzeitpunkte des Transistors 27 kann die Auswertevorrichtung 34 relativ schnell einen sich anbahnenden Defekt des elektronischen Schalters 25 erkennen. Bei geeigneter Auslegung z.B. deutlich schneller als innerhalb von 200ns.

Die Polung des Impulsübertragers 29, seine Anordnung beim Transistor 27 oder bei der Freilaufdiode 26 und die Art seiner Anbindung an den Schwellwertentscheider 30 können frei gewählt werden und erlauben es, entweder den Beginn des Einschaltvorgangs (Aufmagnetisieren der Lastinduktivität, Beginn des Stromflusses in einer resistiven oder kapazitiven Last) oder den Beginn des Abschaltvorgangs (Abmagnetisieren, Freilauf, Abschalten einer anderen Last) auszuwerten.

Die Fig. 3 zeigt eine Ausführungsform in Form einer Computersimulation. Der elektronische Schalter 25 bzw. dessen elektronisches Schaltelement ist dabei als eine schaltbare Stromquelle 41 simuliert, sodass der elektrische Strom der Stromquelle 41 den elektrische Strom i durch den Transistor 27, allgemein durch das elektronische Schaltelement 27 simuliert.

Die Werte des Impulstransformators 29 für die Computersimulation lauten folgendermaßen:

L1=200nF
L2=80$\mu$F
n1=1
n2=20

Im Falle des in der Fig. 3 gezeigten Schaltplans der Computersimulation ist der Impulstransformator 29 sekundärseitig mit einem Tiefpassfilter beschaltet, der einen ersten Widerstand R1, einen ersten Kondensator C1 und einen zum ersten Kondensator C1 parallel geschalteten zweiten Widerstand R2 aufweist. Die Werte dieser Bauelemente lauten folgendermaßen:

R1=100$\Omega$
R2=10k$\Omega$
C1=1nF

Dem Tiefpassfilter nachgeschaltet ist ein Schwellwertentscheider 42, an dessen Eingang 43 eine elektrische Spannung anliegt. Im Falle des vorliegenden Ausführungsbeispiels ist parallel zum zweiten Widerstand R2 und dem ersten Kondensator C1 eine Diode D derart geschaltet, dass an den Eingänge 43 nur positive elektrische Spannungen anliegen.

Die am Eingang 43 des Schwellwertentscheiders 42 anliegende elektrische Spannung ist somit eine mittels des Tiefpassfilters gefilterte sekundärseitige elektrische Spannung U2' des Impulsübertragers 29, wobei negative Spannungswerte durch die Diode D herausgefiltert sind.

Der Schwellwertentscheider 42 ist im Falle des vorliegenden Ausführungsbeispiels ein gesteuerter Schalter, welcher schließt, sobald die an seinem Eingang 43 anliegende elektrische Spannung größer gleich einer Referenzspannung ist. Die Referenzspannung ist im Falle des vorliegenden Ausführungsbeispiels 1,0V, sodass der Schalter schließt, sobald die gefilterte sekundärseitige elektrische Spannung U2' größer gleich 1,0V ist und wieder öffnet, wenn die gefilterte sekundärseitige elektrische Spannung U2' kleiner als 1,0V ist.

Der Schwellwertenscheider 42 ist z.B. ein bipolarer Transistor und weist eine Ausgangsspannung U auf.

Die Schaltung der Fig. 3 umfasst noch einen dritten Widerstand R3 (220$\Omega$) und einen zweiten Kondensator C2 (10nF), die jeweils mit einem ihrer Anschlüsse mit einem Knoten K verbunden sind. Der andere Anschluss des zweiten Kondensators C2 ist mit Masse verbunden.

Es ist ferner eine Spannungsquelle V vorgesehen, die eine Gleichspannung von 1,0V erzeugt. Die Spannungsquelle V ist einerseits mit Masse und andererseits mit dem dritten Widerstand R3 verbunden.

Der Schalter des Schwellwertentscheiders 42 ist mit dem Knoten K und Masse verbunden.

Da der Schalter des Schwellwertentscheiders 42 geöffnet ist, wenn die gefilterte sekundärseitige elektrische Spannung U2' an seinem Eingang 43 kleiner als 1,0V ist, ist die Ausgangsspannung U gleich 1,0V, solange die gefilterte sekundärseitige elektrische Spannung U2' an seinem Eingang 43 kleiner als 1,0V ist. Ist die gefilterte sekundärseitige elektrische Spannung U2' am Eingang 43 größer gleich 1,0V, dann schließt der Schalter des Schwellwertentscheiders 42 und die Ausgangsspannung U wird zu Null.

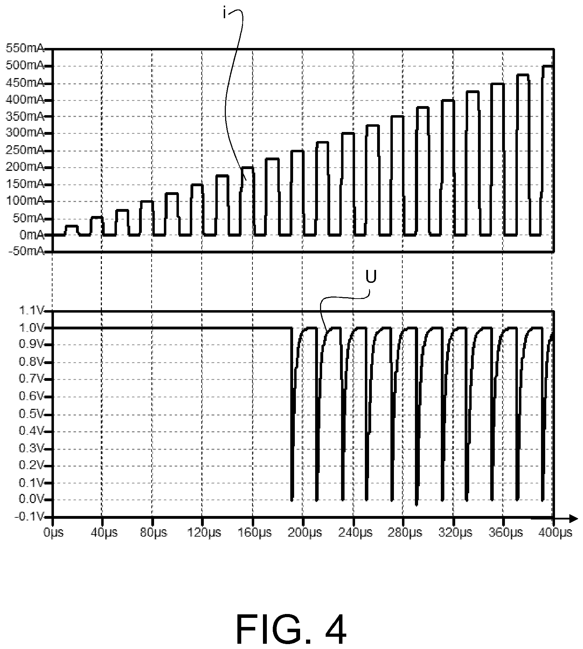

Um die Schaltung der Fig. 3 zu testen, erzeugt die Stromquelle 41 unterschiedlich hohe Impulse des elektrischen Stroms i (Stromimpulse), die in der Fig. 4 gezeigt sind. Die Anstiegs- und Abfallzeiten der Stromimpulse sind stets 1 $\mu$s, so dass aus der unterschiedlichen Impulshöhe und der immer gleichen Anstiegs- und Abfallzeit zum Nachweis des Funktionsprinzips Impulse mit unterschiedlich hoher Stromänderungsrate di/dt entstehen.

Die Stromimpulse werden durch die Primärseite des Impulsübertragers 29 geschickt. Das Verhältnis der beiden Induktivitäten L1 und L2 (1:400) entspricht einem Windungszahlverhältnis bzw. Übertragungsverhältnis von 1:20.

Die sekundärseitige elektrische Spannung U2 des Impulsübertragers 29 wird durch den Tiefpassfilter und der Diode D gefiltert und begrenzt, ohne jedoch den Ausgang des Impulsübertragers 29, d.h. sekundärseitig nennenswert zu belasten und die Eigenschaften auf der Primärseite des Impulsübertragers 29 merklich zu verändern.

Aufgrund der Werte des Impulsübertragers 29 ergibt sich, dass ab einer Änderung des elektrischen Stroms i von 250 mA / μs die Entscheidungsschwelle von 1,0 V erreicht wird und ein auswertbares Signal (Ausgangsspannung U) entsteht.

Die Fig. 4 zeigt, dass ab einer Änderung des elektrischen Stroms i von di/dt = 250 mA / μs in der primärseitigen Wicklung W1 des Impulsübertragers 29 ein Ausgangssignal U entsteht, das eine für das gewählte Zahlenbeispiel ausreichend schnelle Stromänderung anzeigt.

Die in der Fig. 4 gezeigten Stromimpulse weisen eine Stromänderungsrate di/dt in folgenden Höhen auf:

25 mA / μs; 50 mA / μs; 75 mA / μs; 100 mA / μs; 125 mA / μs; 150 mA / μs; 175 mA / μs; 200 mA / μs; 225 mA / μs; 250 mA / μs; 275 mA / μs; 300 mA / μs; 325 mA / μs; 350 mA / μs; 375 mA / μs; 400 mA / μs; 425 mA / μs; 450 mA / μs; 475 mA / μs; 500 mA / μs;

Das Tiefpassfilter vermag eingekoppelte Störungen zu dämpfen, die zu einem ungewollten Auslösen des Schwellwertentscheiders führen könnten.

**Patentansprüche**

1.  Elektrische Vorrichtung, aufweisend

    - einen elektrischen Verbraucher (22),
    - einen elektronischen Schalter (25), der ein elektronisches Schaltelement (27) und eine das elektronische Schaltelement (27) ansteuernde Treibervorrichtung (28) umfasst,
    - ein getaktetes Netzteil (20), welches ein Leistungsteil (23) mit dem elektronischen Schaltelement (27) aufweist und das eingerichtet ist, aus einer elektrischen Spannung aufgrund eines abwechselnden Ein- und Ausschaltens des einen elektronischen Schaltelements (27) eine elektrische Versorgungsspannung oder einen elektrischen Versorgungsstrom für den elektrischen Verbraucher (22) zu erzeugen, wobei das Leistungsteil (23) einen Strompfad (12) aufweist, durch den im Betrieb des Netzteils (20) ein dem elektronischen Schaltelement (27) des elektronischen Schalters (25) zugeordneter elektrischer Strom (i) fließt,

    - wenigstens einen Impulsübertrager (29), der eine Primärseite mit einer primärseitigen Wicklung (W1) und wenigstens eine Sekundärseite mit wenigstens einer sekundärseitigen Wicklung (W2) aufweist und der mit seiner Primärseite derart in das Leistungsteil (23) geschaltet ist, dass durch die primärseitige Wicklung (W1) der dem elektronischen Schaltelement (27) des elektronischen Schalters (25) zugeordnete elektrischer Strom (i) fließt, **dadurch gekennzeichnet, dass** der Impulsübertrager (29) auf seiner Sekundärseite derart schwach belastet ist, dass die an der sekundärseitigen Wicklung (W2) anliegende sekundärseitige elektrische Spannung (U2) zumindest annähernd proportional zur zeitlichen Änderung des dem elektronischen Schaltelement (27) des elektronischen Schalters (25) zugeordneten elektrischen Stroms (i) ist,
    - einen Schwellwertentscheider (30, 42), der eingerichtet ist, die sekundärseitige elektrische Spannung (U2) oder eine durch Filterung erzeugte gefilterte sekundärseitige elektrische Spannung (U2') mit einer Referenzspannung zu vergleichen, die insbesondere einer zeitlichen Änderung eines elektrischen Stromes zugeordnet ist, die dem vollständig funktionstüchtigen elektronischen Schalter (25) zugeordnet ist, und
    - eine mit dem Schwellwertentscheider (30, 42) gekoppelte Auswertevorrichtung (34), welche eingerichtet ist, aufgrund des mit dem Schwellwertentscheider (30, 42) durchgeführten Vergleichs einen potenziellen Defekt des elektronischen Schalters (25) zu erkennen.

2.  Elektrische Vorrichtung nach Anspruch 1, bei der der elektronische Schalter (25) ein Halbleiterschalter ist und das elektronische Schaltelement als ein Transistor (27) ausgebildet ist, und/oder bei der der elektrische Verbraucher (22) ein induktiver Verbraucher ist, und/oder deren Leistungsteil (23) als eine H-Brücke ausgebildet ist.

3.  Elektrische Vorrichtung nach Anspruch 1 oder 2, bei der das elektronische Schaltelement (27) Teil des Strompfades (12) ist, durch den im Betrieb des Netzteils (20) der dem elektronischen Schaltelement (27) des elektronischen Schalters (25) zugeordnete elektrische Strom (i) fließt.

4.  Elektrische Vorrichtung nach einem der Ansprüche 1 bis 3, bei der die Auswertevorrichtung (34) eingerichtet ist, aufgrund des mit dem Schwellwertentscheider (30, 42) durchgeführten Vergleichs für einen Ein- oder Ausschaltvorgang des elektronischen Schaltelemets (27) einen potenziellen Defekt des elektronischen Schalters (25) zu erkennen.

**5.** Elektrische Vorrichtung nach einem der Ansprüche 1 bis 4, bei der die sekundärseitige elektrische Spannung (U2) sich zumindest annähernd gemäß folgender Gleichung ergibt:

$$U2 = n2/n1*L1*di/dt$$

wobei n1 die Windungen der primärseitigen der primärseitigen Wicklung (W1), n2 die Windungen der sekundärseitigen Wicklung (W2), L1 die primärseitige Induktivität der primärseitigen Wicklung (W1, L2) die sekundärseitige Induktivität der sekundärseitigen Wicklung (W2) und di/dt die Änderung des dem elektronischen Schaltelement (27) zugeordneten elektrischen Stroms (i) ist.

**6.** Elektrische Vorrichtung nach einem der Ansprüche 1 bis 5, bei der der Schwellwertenscheider (30, 42) ein Ausgangssignal erzeugt, welches sich ändert, sobald die sekundärseitige elektrische Spannung (U2) oder die gefilterte sekundärseitige elektrische Spannung (U2') die Referenzspannung überschreitet.

**7.** Elektrische Vorrichtung nach einem der Ansprüche 1 bis 6, dessen Auswertevorrichtung (34) eingerichtet ist, auf einen potenziellen Defekt des elektronischen Schalters (25) zu schließen, wenn trotz eines Ein- oder Ausschaltvorgangs des elektronischen Schaltelements (27) die sekundärseitige elektrische Spannung (U2) oder die gefilterte sekundärseitige elektrische Spannung (U2') die Referenzspannung stets unterschreitet.

**8.** Elektrische Vorrichtung nach einem der Ansprüche 1 bis 7, aufweisend einen dem Impulsübertrager (29) sekundärseitig nachgeschalteten Tiefpassfilter, der eingerichtet ist, aus der sekundärseitigen elektrischen Spannung (U2) die gefilterte sekundärseitige elektrische Spannung (U2') zu erzeugen.

**9.** Verfahren zum Überprüfen des Netzteils (20) der elektrischen Vorrichtung (1) nach einem der Ansprüche 1 bis 8, aufweisend folgende Verfahrensschritte:

- abwechselndes Öffnen und Schließen des elektrischen Schaltelements (27),
- Vergleichen der sekundärseitige elektrische Spannung (U2) oder der gefilterten sekundärseitigen elektrischen Spannung (U2') mit der Referenzspannung, und
- Schließen auf einen potenziellen Defekt des elektronischen Schalters (25) aufgrund des Vergleichs.

**10.** Verfahren nach Anspruch 9, aufweisend Schließen auf einen potenziellen Defekt des elektronischen Schalters (25), wenn trotz eines Ein- oder Ausschaltvorgangs des elektronischen Schaltelements (27) die sekundärseitige elektrische Spannung (U2) oder die gefilterte sekundärseitige elektrische Spannung (U2') die Referenzspannung stets unterschreitet.

**Claims**

**1.** Electrical device, comprising

- an electrical consumer unit (22),
- an electronic switch (25) including an electronic switching element (27) and a driver device (28) controlling the electronic switching element (27),
- a pulsed power supply (20) having a power unit (23) with the electronic switching element (27) and configured to generate an electrical supply voltage or an electrical supply current for the electrical consumer unit (22) from an electrical voltage based on an alternate powering on and off of the electronic switching element (27), the power unit (23) having a current path (12) through which an electrical current (i) flows associated with the electronic switching element (27) of the electronic switch (25) during operation of the power supply (20),
- at least one pulse transformer (29) having a primary side with a primary-side winding (W1) and at least one secondary side with at least one secondary-side winding (W2) and which is coupled with the power unit (23) by its primary side in such a way that electrical current (i) associated with the electronic switching element (27) of the electronic switch (25) flows through the primary-side winding (W1),

**characterised in that**
the pulse transformer (29) is lightly loaded on its secondary side such that the secondary-side electrical voltage (U2) across the secondary-side winding (W2) is at least approximately proportional to the rate of change of the electrical current (i) associated with the electronic switching element (27) of the electronic switch (25),

- threshold comparator (30, 42) which is configured to compare the secondary-side electrical voltage (U2) or a filtered secondary-side electrical voltage (U2') that is generated by filtering with a reference voltage that is associated in particular with a time change of an electrical current which is associated with the fully functioning electronic switch (25) and
- an evaluation device (34) coupled with the threshold comparator (30, 42) which evaluation device is configured to detect a potential defect of the electronic switch (25) based on the comparison implemented by the threshold comparator (30, 42).

2. Electrical device according to claim 1, wherein the electronic switch (25) is a semi-conductor switch and the electronic switching element is designed as a transistor (27), and/or the electrical consumer unit (22) is an inductive consumer unit and/or its power unit (23) is designed as an H-bridge.

3. Electrical device according to claim 1 or 2, wherein the electronic switching element (27) is part of the current path (12) through which the electrical current (i) associated with the electronic switching element (27) of the electronic switch (25) flows during operation of the power supply (20).

4. Electrical device according to any of claims 1 to 3, wherein the evaluation device (34) is configured to detect a potential defect of the electronic switch (25) based on the comparison performed by the threshold comparator (30, 42) for a power-on or power-off process of the electrical switching element (27).

5. Electrical device according to any of claims 1 to 4, wherein the secondary-side electrical voltage (U2) is at least approximately determined according to the following equation:

$$U2 = n2/n1 * L1 * di/dt$$

wherein n1 is the number of windings of the primary-side winding (W1), n2 is the number of windings of the secondary-side winding (W2), L1 is the primary-side inductance of the primary-side winding (W1, L2) the secondary-side inductance of the secondary-side winding (W2) and di/dt is the change of the electrical current (i) associated with the electronic switching element (27).

6. Electrical device according to any of claims 1 to 5, wherein the threshold comparator (30, 42) generates an output signal that changes as soon as the secondary-side electrical voltage (U2) or the filtered secondary-side electrical voltage (U2') exceeds the reference voltage.

7. Electrical device according to any of claims 1 to 6, wherein the evaluation device (34) is configured to determine a potential defect of the electronic switch (25) when, despite a power-on or power-off process of the electronic switching element (27), the secondary-side electrical voltage (U2) or the filtered secondary-side electrical voltage (U2') is always lower than the reference voltage.

8. Electrical device according to any of claims 1 to 7, comprising a secondary-side low-pass filter coupled downstream of the pulse transformer (29) and configured to generate the filtered secondary-side electrical voltage (U2') from the secondary-side electrical voltage (U2).

9. Method for monitoring the power supply (20) of the electrical device (1) according to any of claims 1 to 8, comprising the following method steps:

- alternately opening and closing the electric switching element (27),
- comparing the secondary-side electrical voltage (U2) or the filtered secondary-side electrical voltage (U2') with the reference voltage, and
- determining a potential defect of the electronic switch (25) based on the comparison.

10. Method according to claim 9, wherein a potential defect of the electronic switch (25) is determined when, despite a power-on or power-off process of the electronic switching element (27), the secondary-side electrical voltage (U2) or the filtered secondary-side electrical voltage (U2') is always lower than the reference voltage.

**Revendications**

1. Dispositif électrique présentant

- un consommateur électrique (22),
- un commutateur électronique (25) comprenant un élément de commutation électronique (27) et un dispositif de commande (28) pilotant l'élément de commutation électronique (27),
- un bloc d'alimentation cadencé (20) qui présente une partie de puissance (23) avec ledit élément de commutation électronique (27) et qui est conçu pour générer, à partir d'une tension électrique due à la mise en marche et à l'arrêt alternés dudit un élément de commutation électronique (27), une tension d'alimentation électrique ou en un courant d'alimentation électrique pour le consommateur électrique (22), la partie de puissance (23) présentant un trajet de courant (12) à travers lequel un courant électrique (i) associé à l'élément de commutation électronique (27) du commutateur électronique (25) circule pendant le fonctionnement du bloc d'alimentation (20),
- au moins un transformateur d'impulsions (29) qui présente un côté primaire avec un enroulement côté primaire (W1) et au moins un côté secondaire avec au moins un enroulement côté secondaire (W2) et qui est connecté avec son côté primaire à la partie de puissance (23) de telle sorte que le courant électrique (i) associé à l'élément de commutation électronique (27) du commutateur électronique (25) circule à travers l'enroulement côté primaire (W1),

**caractérisé en ce que**
le transformateur d'impulsions (29) est si faiblement chargé sur son côté secondaire que la tension électrique du côté secondaire (U2) appliquée à l'enroulement du côté secondaire (W2) est au moins approximativement proportionnelle à la variation dans le temps du courant électrique (i) associé à l'élément de commutation électronique (27) du commutateur électronique (25),

- un décideur de valeur seuil (30, 42) qui est conçu pour comparer la tension électrique secondaire (U2) ou une tension électrique secondaire filtrée (U2') générée par filtrage avec une tension de référence qui est associée, en particulier, à une variation temporelle d'un courant électrique qui est associée au commutateur électronique entièrement fonctionnel (25), et
- un dispositif d'évaluation (34) couplé au décideur de valeur seuil (30, 42), qui est conçu pour détecter un défaut potentiel du commutateur électronique (25) sur la base de la comparaison effectuée avec le décideur de valeur seuil (30, 42).

2. Dispositif électrique selon la revendication 1, dans lequel le commutateur électronique (25) est un commutateur semi-conducteur et l'élément de commutation électronique est réalisé sous la forme d'un transistor (27), et/ou dans lequel le consommateur électrique (22) est un consommateur inductif, et/ou dont la partie de puissance (23) est réalisée sous la forme d'un pont en H.

3. Dispositif électrique selon la revendication 1 ou 2, dans lequel l'élément de commutation électronique (27) fait partie du trajet de courant (12) à travers lequel le courant électrique (i) associé à l'élément de commutation électronique (27) du commutateur électronique (25) circule pendant le fonctionnement du bloc d'alimentation (20).

4. Dispositif électrique selon l'une des revendications 1 à 3, dans lequel le dispositif d'évaluation (34) est conçu pour détecter un défaut potentiel du commutateur électronique (25) sur la base de la comparaison effectuée avec le décideur de valeur seuil (30, 42) pour une opération de mise sous ou hors tension de l'élément de commutation électronique (27).

5. Dispositif électrique selon l'une des revendications 1 à 4, dans lequel la tension électrique du côté secondaire (U2) résulte au moins approximativement de l'équation suivante :

$$U2 = n2/n1 * L1 * di/dt$$

dans laquelle n1 sont les spires de l'enroulement côté primaire (W1), n2 sont les spires de l'enroulement côté secondaire (W2), L1 est l'inductance côté primaire de l'enroulement côté primaire (W1), L2 est l'inductance côté secondaire de l'enroulement côté secondaire (W2) et di/dt est la variation du courant électrique (i) associé à l'élément de commutation électronique (27).

6. Dispositif électrique selon l'une quelconque des revendications 1 à 5, **caractérisé en ce que** le décideur de valeur de seuil (30, 42) génère un signal de sortie qui change dès que la tension électrique côté secondaire (U2) ou la tension électrique côté secondaire filtrée (U2') dépasse la tension de référence.

7. Dispositif électrique selon l'une des revendications 1 à 6, dont le dispositif d'évaluation (34) est conçu pour conclure un défaut potentiel du commutateur électronique (25) lorsque, en dépit d'une opération de mise sous ou hors tension de l'élément de commutation électronique (27), la tension électrique côté secondaire (U2) ou la tension électrique côté secondaire filtrée (U2') devient toujours inférieure à la tension de référence.

8. Dispositif électrique selon l'une quelconque des revendications 1 à 7, présentant un filtre passe-bas en aval du transformateur d'impulsions (29) du côté secondaire et qui est conçu pour générer la tension électrique filtrée du côté secondaire (U2') à partir de la tension électrique du côté secondaire (U2),

9. Procédé de contrôle du bloc d'alimentation (20) du dispositif électrique (1) selon l'une des revendications 1 à 8, comprenant les étapes de procédé suivantes

- ouvrir et fermer en alternance l'élément de commutation électrique (27),
- comparer la tension électrique côté secondaire (U2) ou la tension électrique côté secondaire filtrée (U2') avec la tension de référence, et
- déduire un défaut potentiel de l'interrupteur électronique (25) sur la base de la comparaison.

10. Procédé selon la revendication 9, comprenant la déduction d'un défaut potentiel du commutateur électronique (25) lorsque, en dépit d'une opération de mise sous ou hors tension de l'élément de commutation électronique (27), la tension électrique côté secondaire (U2) ou la tension électrique côté secondaire filtrée (U2') devient toujours inférieure à la tension de référence.

FIG. 1

# FIG. 2

# FIG. 3

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012219318 A1